# FASCICULE DE BREVET EUROPEEN

(11) **EP 3 347 322 B1**
(45) Date de publication et mention de la délivrance du brevet: **18.08.2021**
(21) Numéro de dépôt: 16775780.6
(22) Date de dépôt: 05.09.2016
(51) Int. Cl.: C03C 17/36

(54) **VITRAGE COMPRENANT UN EMPILEMENT DE COUCHES MINCES**
GLASUR MIT EINEM STAPEL AUS DÜNNEN SCHICHTEN
GLAZING INCLUDING A STACK OF THIN LAYERS

(30) Priorité: 08.09.2015 FR 1558308
(43) Date de publication de la demande: 18.07.2018
(73) Titulaire: SAINT-GOBAIN GLASS FRANCE, 92400 Courbevoie (FR)
(72) Inventeur: CAILLET, Xavier, 94120 Fontenay Sous Bois (FR); KHARCHENKO, Andriy, 91120 Palaiseau (FR)
(74) Mandataire: Saint-Gobain Recherche
(86) Numéro de dépôt international: PCT/FR2016/052198
(87) Numéro de publication internationale: WO 2017/042463

(56) Documents cités:
- EP-A2- 1 734 019
- WO-A1-2007/042688
- WO-A1-2007/101964
- WO-A1-2012/127162
- WO-A2-03/048061
- US-A1- 2005 042 460
- US-A1- 2005 191 501

## Description

L'invention concerne un matériau et un procédé d'obtention d'un matériau, tel qu'un vitrage, comprenant un substrat transparent revêtu d'un empilement de couches minces comprenant une couche fonctionnelle à base d'argent.

L'invention concerne plus particulièrement l'utilisation de tels matériaux pour fabriquer des vitrages d'isolation thermique renforcée présentant un facteur solaire élevé. De tels vitrages sont par exemple destinés aux climats froids pour équiper les bâtiments, en vue notamment de diminuer l'effort de chauffage en hiver (vitrages dits « bas-émissifs») et de maximiser l'apport solaire gratuit.

Le facteur solaire g est défini comme le rapport entre l'énergie entrant dans le local par le vitrage et l'énergie solaire incidente. Il peut être calculé par la somme du flux énergétique transmis directement à travers le vitrage et du flux énergétique absorbé puis réémis vers l'intérieur par le vitrage. Le facteur solaire g, aussi appelé coefficient FS, est mesuré au sens de l'invention selon les conditions décrites dans la norme internationale ISO 9050.

Un type d'empilement de couches minces connu pour conférer de telles propriétés d'isolation thermique est constitué d'une couche fonctionnelle à base d'argent (ou couche d'argent).

Les couches fonctionnelles à base d'argent sont utiles à plusieurs titres : en réfléchissant le rayonnement infrarouge, thermique ou solaire, elles impartissent au matériau des fonctions de basse émissivité ou de contrôle solaire. Conductrices de l'électricité, elles permettent également d'obtenir des matériaux conducteurs, par exemple des vitrages chauffants ou des électrodes.

Les couches fonctionnelles à base d'argent sont déposées entre des revêtements à base de matériaux diélectriques (ci-après revêtement diélectrique) qui comprennent généralement plusieurs couches diélectriques permettant d'ajuster les propriétés optiques de l'empilement et de conserver une transmission élevée dans le domaine visible. Ces couches diélectriques permettent en outre de protéger les couches d'argent des agressions chimiques ou mécaniques.

La demande WO 2012/127162, appartenant à la déposante, divulgue un matériau comprenant un substrat transparent muni d'un empilement de couches minces comprenant une couche d'argent disposée entre deux revêtements diélectriques non métalliques particuliers permettant d'augmenter le facteur solaire d'un vitrage équipé d'un tel matériau et d'obtenir une coloration acceptable, notamment en transmission. A cette fin, l'empilement comprend de préférence :
- un revêtement diélectrique inférieur, situé en dessous de la couche d'argent, comprenant au moins une couche à haut indice de réfraction, en matériau d'indice de réfraction supérieur ou égal à 2,20, présentant une épaisseur de préférence supérieure à 10 nm,
- un revêtement diélectrique supérieur, situé au-dessus de la couche d'argent comprenant au moins la séquence de couches minces haut et bas indices déposées dans l'ordre suivant au-dessus de la couche à base d'argent :
   - au moins une couche à haut indice de réfraction, en matériau d'indice de réfraction supérieur ou égal à 2,20, l'épaisseur physique de la couche à haut indice de réfraction ou la somme des épaisseurs physiques des couches à haut indice de réfraction étant comprise entre 15 et 40 nm,
   - au moins une couche à bas indice de réfraction, en matériau d'indice de réfraction inférieur ou égal à 1,70, l'épaisseur physique de la couche à bas indice de réfraction ou la somme des épaisseurs physiques des couches à bas indice de réfraction étant comprise entre 40 et 120 nm.

Ces matériaux comprenant des couches minces haut et bas indices présentent avantageusement un facteur solaire élevé, une transmission lumineuse élevée et des couleurs en transmission et en réflexion acceptables.

En revanche, lorsque ces matériaux subissent des traitements thermiques à température élevée, une variation des propriétés colorimétriques et optiques, notamment une augmentation de la proportion de lumière diffusée, non satisfaisante pour certaines applications est souvent observée.

On observe suite à un traitement thermique de type trempe une diffusion importante de la lumière ainsi qu'une variation des couleurs particulièrement marquée en réflexion et également visible en transmission. Les phénomènes de diffusion de la lumière se traduisent visuellement par l'apparition d'un halo lumineux appelé « flou », visible généralement sous lumière intense.

La stabilité des propriétés colorimétriques et optiques permet avantageusement d'utiliser simultanément dans un même ensemble des matériaux non soumis à un traitement thermique et d'autres ayant subi un traitement thermique, sans que les différences qui peuvent en résulter soient trop manifestes. Des matériaux de ce type peuvent être qualifiés de « appariable » (« matchable ») ou « trempable » dans la mesure ou les variations de couleurs, avant et après traitement thermique, ne sont pas visibles à l'œil nu.

Par conséquent, les matériaux décrits dans la demande WO 2012/127162 ne présentent pas, pour certaines applications, des propriétés colorimétriques et éventuellement optiques suffisamment voisines, avant et après traitement thermique, pour être utilisés conjointement et donc être qualifiés de matériau appariable ou trempable. L'esthétique des matériaux avant et après traitement thermique n'est pas suffisamment proche.

Il existe donc un besoin de développer un matériau présentant à la fois :
- des propriétés optiques et colorimétriques suffisamment voisines, avant et après traitement thermique et, éventuellement,
- un facteur solaire élevé, une transmission lumineuse élevée et des couleurs en transmission et en réflexion acceptables.

Selon la présente l'invention, des matériaux présentant des variations des facteurs lumineux suite au traitement thermique ne sont pas exclus de la définition de matériau appariable. On préfère toutefois que les variations des facteurs lumineux suite au traitement thermique restent les plus faibles possibles.

Par conséquent, le matériau de l'invention doit pouvoir subir un traitement thermique à température élevée tel qu'un recuit, un bombage et/ou une trempe, sans que ce traitement ne provoque des modifications au sein de l'empilement de couches minces.

Les propriétés des empilements à base d'argent, tels que les performances énergétiques ou optiques, dépendent directement de la qualité des couches d'argent telle que leur état cristallin, leur homogénéité ainsi que de leur environnement, par exemple de la nature des couches situées au-dessus et en-dessous. De plus, ces propriétés résultent également d'un contrôle précis des effets d'interférences optiques entre les différentes couches composant l'empilement.

Des solutions pour améliorer la qualité des couches d'argent et notamment leur cristallisation ont été proposées bien avant le dépôt de la demande WO 2012/127162 divulguant des empilements comprenant notamment une séquence de couches minces haut et bas indices.

Par exemple, il est connu de la demande WO 2007/042688 des matériaux présentant une transmission lumineuse élevée comprenant dans le revêtement diélectrique inférieur une couche haut indice et une couche de mouillage. De tels matériaux ont pour inconvénient de présenter un léger flou suite à un traitement thermique à température élevé. Pour pallier ce problème, la solution proposée dans la demande WO 2007/042688 consiste à utiliser un revêtement diélectrique situé en dessous de la couche d'argent comprenant :
- une couche haut-indice, par exemple une couche de dioxyde de titane,
- une couche anti-diffusion à base d'oxyde mixte de nickel et de chrome (NiCrOx) ou d'indium et d'étain (InSnOx) située au-dessus de la couche haut-indice,
- une couche de mouillage constitué essentiellement d'oxyde de zinc située au-dessus de la couche anti-diffusion.

La solution proposée dans cette demande pour limiter le flou après traitement thermique consiste donc à utiliser un revêtement diélectrique inférieur, c'est-à-dire situé en dessous d'une couche d'argent, comprenant la séquence de couches suivantes : une couche haut indice / une couche anti-diffusion à base d'oxydes mixtes spécifiques / une couche de mouillage.

Les matériaux décrits et exemplifiés dans la demande WO 2007/042688 ne comprennent pas une séquence de couches haut et bas indices dans le revêtement diélectrique supérieur.

La demande WO 2007/101964 divulgue, dans le cas où le revêtement diélectrique situé en dessous de la couche d'argent comprend au moins une couche diélectrique à base de nitrure, notamment de nitrure de silicium et/ou d'aluminium, d'utiliser des revêtements diélectriques comprenant :
- des couches de mouillage destinées à favoriser le mouillage et la nucléation de la couche d'argent, par exemple une couche à base d'oxyde de zinc cristallisé,
- des couches de lissage en un oxyde mixte situé sous la couche de mouillage contribuant à la croissance adéquate de la couche d'argent au-dessus de la couche de mouillage.

Les couches à base de nitrure de silicium et/ou d'aluminium présentes dans le revêtement diélectrique situé en dessous de l'argent ont une épaisseur d'au moins 10 nm, notamment de 30 nm et 20 nm dans les exemples 2 à 4 (tableau 1).

Selon la demande WO 2007/101964, ces matériaux permettent d'obtenir des propriétés optiques satisfaisantes que le substrat subisse ou non un traitement thermique après dépôt. Cependant, les matériaux décrits et exemplifiés ne comprennent pas des séquences de couches haut et bas indices.

Dans ces deux documents, toutes les couches minces du revêtement diélectrique supérieur, présentant une épaisseur supérieure à 5 nm, ont des indices de réfraction sensiblement égaux.

De ce fait, les revêtements diélectriques constitués de telles couches minces forment un milieu d'indice de réfraction sensiblement homogène bien que les matériaux qui les constituent soient différents.

Les documents WO 03/048061 A2, EP 1 734 019 A2, US 2005/042460 A1 et US 2005/191501 A1 décrivent d'autres revêtements à faible émissivité avec une couche d'argent.

Selon l'invention, deux couches minces ont des indices de réfraction sensiblement égaux, lorsque la valeur absolue de la différence entre les indices de réfraction des deux matériaux constituant lesdites couches à 550 nm est inférieure ou égale à 0,15.

Le demandeur a découvert, de manière surprenante, que la variation des propriétés optiques, suite à un traitement thermique à température élevée de type trempe, des empilements comprenant un revêtement diélectrique inférieur comprenant la séquence de couches suivantes :
- une couche haut-indice,
- au moins une couche à base d'oxyde telle qu'une couche de lissage à base d'oxydes mixtes et/ou une couche de mouillage,
est due à l'inter-diffusion d'éléments des couches haut-indice et des couches d'oxyde, lorsque la couche haut indice présente une épaisseur supérieure à 5 nm.

Par exemple, dans le cas d'un revêtement diélectrique comprenant la séquence de couches suivantes : TiOx / SnZnOx / ZnO, on observe :
- la migration d'étain et de zinc vers la couche d'oxyde de titane,
- la migration de titane vers la couche d'oxyde mixte de zinc et d'étain,
- la migration d'oxygène de la couche d'oxyde de zinc et d'étain vers la couche d'oxyde de titane.

Toutefois, bien que ce phénomène d'inter-diffusion intervienne dès qu'un traitement thermique à température élevée est réalisé, une variation significative des couleurs ne semble être observée que lorsque le revêtement diélectrique supérieur ne forme pas un milieu d'indice de réfraction homogène. Une variation significative des couleurs se présente notamment lorsque le revêtement diélectrique supérieur comprend plusieurs couches d'épaisseur supérieure à 5 nm dont la différence d'indice de réfraction est au moins supérieure à 0,30.

Par exemple, lorsque le revêtement diélectrique supérieur est :
- essentiellement constitué d'une couche de nitrure de silicium et/ou d'aluminium,
- constitué de plusieurs couches d'oxyde mixte de zinc et d'étain et de nitrure de silicium, matériaux ayant des indices de réfraction sensiblement égaux,
l'indice de réfraction du revêtement diélectrique est homogène et on observe peu de diffusion suite au traitement thermique. Lorsque le revêtement diélectrique supérieur comprend une séquence haut et bas indices, son indice de réfraction n'est pas homogène et l'on observe une diffusion significative suite au traitement thermique.

Il semble donc que le phénomène d'inter-diffusion a un effet négatif significatif sur les variations de couleurs lorsque les couches constituant le revêtement diélectrique supérieur sont constituées de matériaux d'indices de réfraction différents.

Pour pallier ce problème, l'invention consiste à ajouter une couche anti-diffusion spécifique empêchant l'inter-diffusion des éléments des couches haut-indice et des couches d'oxyde. Cette couche anti-diffusion empêche le mélange des matériaux constituant respectivement ces deux couches en bloquant, par exemple, la diffusion du titane dans la couche d'oxyde mixte de zinc et d'étain et de l'étain et du zinc dans la couche d'oxyde de titane.

En empêchant ce phénomène, il semble que l'on prévient la modification des indices de réfraction des couches constituant l'empilement, modification responsable des variations colorimétriques et éventuellement optiques de type diffusion de la lumière, rendant les produits avec et sans traitement thermique, par exemple trempés et non trempés, non appariables.

L'invention permet donc de diminuer les variations optiques, suite à un traitement thermique à température élevée de type trempe, dues à la présence d'une couche haut-indice, d'une couche d'oxyde telle qu'une couche de lissage à base d'oxydes mixtes et/ou d'une couche de mouillage dans un même revêtement diélectrique.

L'invention concerne donc un matériau comprenant un substrat transparent revêtu d'un empilement de couches minces comme définit dans la revendication indépendante 1.

L'invention concerne également :
- le procédé d'obtention d'un matériau selon l'invention,
- le vitrage comprenant au moins un matériau selon l'invention,
- l'utilisation d'un vitrage selon l'invention en tant que vitrage d'isolation thermique pour le bâtiment ou les véhicules,
- un bâtiment ou un véhicule comprenant un vitrage selon l'invention.

La solution de l'invention comprend dans le revêtement diélectrique inférieur :
- une couche haut-indice qui permet d'obtenir une transmission lumineuse élevée et contribue à l'obtention d'un facteur solaire élevé,
- une couche anti-diffusion, située entre la couche d'oxyde et la couche haut-indice, qui permet de diminuer les variations optiques suite à un traitement thermique à température élevée.

La solution de l'invention convient particulièrement lorsque le revêtement diélectrique supérieur ne forme pas un milieu d'indice de réfraction homogène. Selon ce mode de réalisation, un revêtement diélectrique supérieur situé au-dessus d'une couche fonctionnelle à base d'argent comprend au moins deux couches minces, chacune d'épaisseur supérieure à 5 nm, dont la différence d'indice de réfraction est supérieure à 0,30.

Bien que la couche anti-diffusion permette de diminuer considérablement le flou après traitement thermique, on observe parfois des variations des propriétés électriques et thermiques telles qu'une augmentation de la résistivité par carré. Ces variations peuvent alors être attribuées non pas à des variations des indices de réfraction des couches constituant les revêtements diélectriques mais à l'apparition de défauts dans la couche d'argent suite au traitement thermique.

Selon la revendication indépendante 1, le revêtement diélectrique situé en dessous de la couche fonctionnelle à base d'argent comprend en outre une couche haut indice présentant une épaisseur inférieure à 5 nm située au-dessus de la couche anti-diffusion et en dessous de la couche fonctionnelle à base d'argent. Cette couche est, selon l'invention, appelée « couche intermédiaire ».

Cette couche intermédiaire est située au-dessus de la couche anti-diffusion et en dessous des couches à base d'oxyde définies ci-dessus. Contrairement aux couches haut indices de plus de 5 nm d'épaisseur, on n'observe pas pour ces épaisseurs une inter-diffusion d'éléments susceptible de générer une diffusion de la lumière significative suite à un traitement thermique. La composition de cette couche haut indice présentant une épaisseur inférieure à 5 nm est bien évidemment différente de la composition de la couche anti-diffusion et de la couche à base d'oxyde.

Même si une certaine quantité d'éléments migre à partir de ou dans ces couches haut indices, les proportions sont insuffisantes pour modifier les indices de réfraction des couches où interviennent ces migrations. De manière surprenante, il s'avère que la présence d'une telle couche intermédiaire limite l'apparition de certains défauts dus au traitement thermique tels que l'apparition de flou attribué à la croissance de défauts dans la couche d'argent (dendrites ou dômes). On obtient une très bonne qualité optique attribuable à la moindre altération de la couche fonctionnelle à base d'argent après traitement thermique, tout en ayant de très faibles variations optiques induites par ce traitement thermique.

L'invention est volontairement non limitée aux matériaux comprenant dans le revêtement diélectrique supérieur une séquence de couches minces haut et bas indices particulière.

En effet, la solution de l'invention consistant à optimiser le revêtement diélectrique inférieur pour empêcher à la fois la variation des indices de réfraction des couches diélectriques le constituant ainsi qu'éventuellement l'apparition de défauts dans la couche d'argent lors d'un traitement thermique convient tout particulièrement lorsque le revêtement diélectrique supérieur comprend une séquence de couche haut et bas indice. Cependant, cette solution peut raisonnablement convenir lorsque les empilements comprennent des revêtements diélectriques supérieurs d'indices de réfraction non homogènes.

Le matériau, c'est-à-dire le substrat transparent revêtu de l'empilement, est destiné à subir un traitement thermique à température élevée de type trempe, recuit ou bombage.

Le matériau selon l'invention est appariable ou trempable en ce que les valeurs d'absorption lumineuse, de transmission lumineuse et d'émissivité ne sont pas substantiellement modifiées lors du traitement thermique.

Les caractéristiques préférées qui figurent dans la suite de la description sont applicables aussi bien au procédé selon l'invention que, le cas échéant, au produit, c'est-à-dire au matériau, avant ou après traitement thermique.

Toutes les caractéristiques lumineuses présentées dans la présente description sont obtenues selon les principes et méthodes décrits dans la norme européenne EN 410 se rapportant à la détermination des caractéristiques lumineuses et solaires des vitrages utilisés dans le verre pour la construction.

Les indices de réfraction sont tous mesurés, comme usuellement, à une longueur d'onde de 550 nm.

Par « épaisseur » sans qualificatif, on entend au sens de l'invention l'épaisseur physique, géométrique ou réelle de la couche avec son indice de réfraction mesuré à 550 nm.

Par « épaisseur optique », on entend au sens de l'invention, comme habituellement, le produit de l'épaisseur physique (ou réelle) de la couche avec son indice de réfraction mesuré à 550 nm.

Par « épaisseur optique totale » on entend au sens de l'invention la somme de toutes les épaisseurs optiques des couches considérées, chaque épaisseur optique étant, comme expliqué ci-avant, le produit de l'épaisseur physique (ou réelle) de la couche avec son indice de réfraction mesuré à 550 nm.

Ainsi, l'épaisseur optique totale du revêtement antireflet est constituée de la somme de toutes les épaisseurs optiques des couches diélectriques constituant ce revêtement.

L'empilement est déposé par pulvérisation cathodique assistée par un champ magnétique (procédé magnétron). Selon ce mode de réalisation avantageux, toutes les couches de l'empilement sont déposées par pulvérisation cathodique assistée par un champ magnétique.

Sauf mention contraire, les épaisseurs évoquées dans le présent document sont des épaisseurs physiques et les couches sont des couches minces. On entend par couche mince, une couche présentant une épaisseur comprise entre 0,1 nm et 100 micromètres.

Dans toute la description le substrat selon l'invention est considéré posé horizontalement. L'empilement de couches minces est déposé au-dessus du substrat. Le sens des expressions « au-dessus » et « en-dessous » et « inférieur » et « supérieur » est à considérer par rapport à cette orientation. A défaut de stipulation spécifique, les expressions « au-dessus » et « en-dessous » ne signifient pas nécessairement que deux couches et/ou revêtements sont disposés au contact l'un de l'autre. Lorsqu'il est précisé qu'une couche est déposée « au contact » d'une autre couche ou d'un revêtement, cela signifie qu'il ne peut y avoir une ou plusieurs couches intercalées entre ces deux couches.

La couche fonctionnelle métallique à base d'argent comprend au moins 95,0 %, de préférence au moins 96,5 % et mieux au moins 98,0 % en masse d'argent par rapport à la masse de la couche fonctionnelle. De préférence, la couche métallique fonctionnelle à base d'argent comprend moins de 1,0 % en masse de métaux autres que de l'argent par rapport à la masse de la couche métallique fonctionnelle à base d'argent.

L'épaisseur de la couche fonctionnelle à base d'argent est par ordre de préférence croissant comprise de 5 à 20 nm, de 8 à 15 nm.

L'empilement de couches minces peut comprendre une seule couche fonctionnelle.

La couche fonctionnelle métallique à base d'argent peut être protégée par une couche qualifiée de couche de blocage. Selon ce mode de réalisation, l'empilement de couches minces comprend en outre au moins une couche de blocage située au contact de la couche fonctionnel métallique choisie parmi les couches métalliques, les couches de nitrure métallique, les couches d'oxyde métallique et les couches d'oxynitrure métallique à base d'un ou plusieurs éléments choisis parmi le niobium Nb, le tantale Ta, le titane Ti, le chrome Cr ou le nickel Ni ou à base d'un alliage obtenu à partir d'au moins deux de ces métaux, notamment d'un alliage de nickel et de chrome (NiCr). Lorsque ces couches de blocage sont déposées sous forme métallique, nitrurée ou oxynitrurée, ces couches peuvent subir une oxydation partielle ou totale selon leur épaisseur et la nature des couches qui les entourent, par exemple, au moment du dépôt de la couche suivante ou par oxydation au contact de la couche sous-jacente.

De préférence, les couches de blocage sont à base de nickel et/ou de chrome et sont des couches métalliques ou des couches d'oxyde métallique, de préférence, sous stœchiométrique en oxygène.

Selon un mode de réalisation avantageux, l'empilement comprend une couche de blocage située au-dessus et au contact de la couche fonctionnelle métallique à base d'argent. En revanche, l'empilement ne comprend pas, de préférence, de couche de blocage située en-dessous et au contact de la couche fonctionnelle métallique à base d'argent.

Chaque couche de blocage présente une épaisseur comprise entre 0,1 et 5,0 nm. L'épaisseur de ces couches de blocage est de préférence :
- d'au moins 0,1 nm ou d'au moins 0,5 nm et/ou
- d'au plus 5,0 nm ou d'au plus 2,0 nm, d'au plus 1,0 nm.

Un exemple d'empilement convenant selon l'invention comprend :
- un revêtement diélectrique inférieur, situé en-dessous de la couche métallique fonctionnelle à base d'argent,
- une couche métallique fonctionnelle à base d'argent,
- une couche de blocage,
- un revêtement diélectrique supérieur, situé au-dessus de la couche métallique fonctionnelle à base d'argent,
- éventuellement une couche de protection.

Les revêtements diélectriques présentent une épaisseur supérieure à 15 nm, de préférence comprise entre 15 et 100 nm.

Les couches diélectriques des revêtements diélectriques présentent les caractéristiques suivantes seules ou en combinaison :
- elles sont déposées par pulvérisation cathodique assistée par champ magnétique,
- elles sont choisies parmi les oxydes, les nitrures ou les oxynitrures d'un ou plusieurs éléments choisi(s) parmi le titane, le silicium, l'aluminium, le zirconium, l'étain et le zinc,
- elles ont une épaisseur supérieure ou égale à 1 nm, de préférence comprise entre 5 et 100 nm.

La ou les couches à base d'oxyde situées au-dessus de la couche anti-diffusion dans le revêtement diélectrique inférieur peuvent comprendre une couche de lissage à base d'oxydes mixtes et/ou une couche de mouillage.

La somme des épaisseurs des couches à base d'oxyde situées au-dessus de la couche anti-diffusion dans le revêtement diélectrique inférieur est par ordre de préférence croissant :
- supérieure à 3,0 nm, supérieure à 5,0 nm, supérieure à 8,0, supérieure à 10 nm, supérieure à 12 nm, supérieure à 15 nm,
- inférieure à 50 nm, inférieure à 40 nm, inférieure à 30 nm, inférieure à 20 nm.

On entend par couche de mouillage, une couche en un matériau apte à stabiliser l'interface avec la couche fonctionnelle. Les couches de mouillage sont à base d'oxyde de zinc, éventuellement dopé à l'aide d'au moins un autre élément, comme l'aluminium. L'oxyde de zinc est cristallisé. La couche à base d'oxyde de zinc comprend, par ordre de préférence croissant au moins 90,0 %, au moins 92 %, au moins 95 %, au moins 98,0 % en masse de zinc par rapport à la masse d'éléments autres que de l'oxygène dans la couche à base d'oxyde de zinc.

Les couches de mouillage ont par ordre de préférence croissant, une épaisseur :
- d'au moins 3,0 nm, d'au moins 5,0 nm, et/ou
- d'au plus 25 nm, d'au plus 10 nm, d'au plus 8,0 nm.

La couche de mouillage peut se trouver directement au contact de la couche métallique fonctionnelle à base d'argent.

Dans un mode de réalisation avantageux, au moins une couche à base d'oxyde située au-dessus de la couche anti-diffusion et présentant une composition différente de la couche anti-diffusion est une couche de mouillage, de préférence à base d'oxyde de zinc, située de préférence directement au contact de la couche métallique à base d'argent.

On entend par couche de lissage, une couche dont la fonction est de favoriser la croissance de la couche de mouillage selon une orientation cristallographique préférentielle, laquelle favorise la cristallisation de la couche d'argent par des phénomènes d'épitaxie. La couche de lissage est située en-dessous et de préférence au-contact d'une couche de mouillage.

La couche de lissage à base d'oxyde mixte peut être qualifiée de « non cristallisée » dans le sens où elle peut être complètement amorphe ou partiellement amorphe et ainsi partiellement cristallisée, mais qu'elle ne peut pas être complètement cristallisée, sur toute son épaisseur. Elle ne peut être de nature métallique car elle est à base d'oxyde mixte (un oxyde mixte est un oxyde d'au moins deux éléments).

L'aspect cristallographique de la couche de lissage est différent de celui de la couche de mouillage puisque la couche de lissage est non cristallisée alors que la couche de mouillage est, pour l'essentiel, cristallisée ; elles ne peuvent donc être confondues de ce point de vue. L'intérêt d'une telle couche de lissage est de permettre d'obtenir une interface avec la couche de mouillage qui est peu rugueuse. Cette faible rugosité est observable au microscope électronique à transmission. Par ailleurs, la couche de mouillage se texture mieux et présente en outre une orientation cristallographique préférentielle plus marquée.

Chaque couche de lissage est ainsi en un matériau différent, tant du point de vue cristallographique que stœchiométrique, de celui de la couche de mouillage sous laquelle elle est directement disposée.

La couche de lissage présente une composition différente de la couche antidiffusion. Cela signifie que dans un même revêtement diélectrique comprenant une couche de lissage à base d'oxyde mixte et une couche anti-diffusion, ces deux couches ne comprennent pas les mêmes éléments selon les mêmes proportions.

De préférence, la couche de lissage, est une couche d'oxyde mixte d'au moins deux métaux choisis parmi Sn, Zn, In, Ga. Un oxyde mixte préféré est l'oxyde de zinc et d'étain. La couche de lissage est de préférence une couche d'oxyde mixte de zinc et d'étain éventuellement dopée.

L'indice de la couche de lissage est, de préférence, inférieur à 2,2. Par ailleurs, la couche de lissage présente de préférence une épaisseur entre 0,1 et 30 nm et de préférence encore comprise entre 0,2 et 10 nm.

Les couches de lissage ont par ordre de préférence croissant, une épaisseur :
- d'au moins 0,5 nm, d'au moins 1,0 nm, d'au moins 5,0 nm, d'au moins 8,0 nm et/ou
- d'au plus 25 nm, d'au plus 20 nm, d'au plus 15 nm.

Selon un mode de réalisation avantageux, le revêtement diélectrique situé en dessous de la couche fonctionnelle à base d'argent comprend comme couches à base d'oxyde :
- une couche de lissage à base d'oxyde mixte, de préférence à base de zinc et d'étain, située au-dessus de la couche anti-diffusion et présentant une composition différente, de préférence la couche de lissage est soit au-contact de la couche antidiffusion ou séparée de la couche anti-diffusion par une couche présentant une épaisseur inférieure à 5 nm, et/ou
- une couche de mouillage à base d'oxyde de zinc, située au-dessus de la couche de lissage.

La couche de lissage et/ou la couche de mouillage sont avantageusement directement au-contact de la couche métallique à base d'argent. Cela signifie que l'empilement ne comprend pas de couche de blocage entre ces couches d'oxyde et la couche métallique à base d'argent.

On entend par couche anti-diffusion, une couche en un matériau apte à faire barrière à la diffusion d'éléments provenant des couches à son contact.

Selon l'invention, une couche à base de silicium et/ou d'aluminium comprend, par ordre de préférence croissant, au moins 30 %, au moins 40 %, au moins 50 %, au moins 60 %, au moins 70 %, au moins 80 %, au moins 90,0 % en masse de silicium et/ou d'aluminium par rapport à la masse d'éléments autres que de l'oxygène et de l'azote dans la couche à base de silicium et/ou d'aluminium.

La couche anti-diffusion à base de silicium et/ou d'aluminium peut être choisie parmi les couches :
- d'oxyde de silicium tels que SiO₂, d'oxyde d'aluminium tels que Al₂O₃ et d'oxyde de silicium et d'aluminium,
- de nitrure de silicium tels que Si₃N₄, de nitrure d'aluminium tels que AIN, de nitrure de silicium et d'aluminium tels que SiAlNₓ, de nitrures de silicium et de zirconium tels que SiZrN,
- d'oxynitrures de silicium tels que SiOₓN_{y}, d'oxynitrures d'aluminium tels que AlOₓN_{y} et d'oxynitrures de silicium et d'aluminium.

De préférence, la couche anti-diffusion à base de silicium et/ou d'aluminium est choisie parmi une couche de nitrure de silicium ou de nitrure de silicium et de zirconium.

La couche anti-diffusion a une épaisseur :
- inférieure ou égale à 10,0 nm, inférieure ou égale à 6,0 nm, inférieure ou égale à 5,0 nm ou inférieure ou égale à 4,0 nm, et/ou
- supérieure ou égale à 1,5 nm, supérieure ou égale à 2,0 nm ou supérieure ou égale à 2,5 nm.

On entend par couche haut indice, une couche à base d'oxyde métallique, présentant un indice de réfraction mesuré à 550 nm, par ordre de préférence croissant, supérieur à 2,30, supérieur à 2,35, supérieur à 2,40.

La couche haut-indice à base d'oxyde métallique est choisie parmi les couches à base d'oxyde de titane, d'oxyde de zirconium, d'oxyde de niobium ou les couche d'un alliage obtenu à partir de titane et d'un autre composant choisi dans le groupe constitué par Zn, Zr et Sn.

L'épaisseur de la couche haut-indice ou la somme des épaisseurs des couches à haut indice de réfraction présentant une épaisseur supérieure à 5 nm situées dans le revêtement diélectrique inférieur est par ordre de préférence croissant comprise entre 5 et 100 nm, entre 8 et 40 nm, entre 10 et 30 nm entre 15 et 25 nm.

Dans le cas où il y a plusieurs couches à haut indice de réfraction présentant une épaisseur supérieure à 5 nm dans le revêtement inférieur, les couches à haut indice de réfraction sont de préférence toutes en contact direct les unes avec les autres. Toutefois, si elles ne sont pas en contact direct les unes avec les autres, elles sont séparées par une couche dont l'indice de réfraction n'est ni inférieur ou égal à 1,70 ni supérieur ou égal à 2,20, l'épaisseur physique de cette couche (chacune de ces couches) de séparation étant inférieure ou égale à 30 nm, de préférence inférieure ou égale à 20 nm.

Avantageusement :
- la couche métallique fonctionnelle à base d'argent est située au-dessus et au contact de la couche de mouillage, et/ou
- la couche de mouillage est située au-dessus et au contact de la couche de lissage, et/ou
- la couche de lissage est située au-dessus et au contact de la couche anti-diffusion ou d'une couche haut indice présentant une épaisseur inférieure à 5 nm (ou couche intermédiaire) et/ou
- la couche anti-diffusion est située au-dessus et au contact de la couche haut indice présentant une épaisseur supérieure à 5 nm (ou couche intermédiaire), et/ou
- la couche haut indice présentant une épaisseur supérieure à 5 nm est située au-dessus et au contact du substrat.

La ou les couches à base d'oxyde telles que la couche de mouillage et la couche de lissage sont soit au-contact de la couche anti-diffusion ou séparées de la couche anti-diffusion par une couche intermédiaire présentant une épaisseur inférieure à 5 nm.

Selon un mode de réalisation avantageux, la couche à base d'oxyde, de préférence, la couche de lissage, est séparée de la couche anti-diffusion par une couche intermédiaire présentant une épaisseur inférieure à 5 nm choisie parmi les couches haut-indice. Cette couche intermédiaire est avantageusement choisies parmi les couches haut-indice à base d'oxyde métallique telles que décrits ci-dessus. La couche intermédiaire est notamment préférentiellement choisie parmi les couches à base d'oxyde de titane.

La couche intermédiaire a, par ordre de préférence croissant, une épaisseur :
- d'au moins 1,0 nm, d'au moins 2,0 nm, et/ou
- d'au plus 5,0 nm, d'au plus 4,0 nm, d'au plus 3,0 nm.

Cette couche intermédiaire peut être située :
- au-dessus de la couche anti-diffusion et en dessous de la couche fonctionnelle à base d'argent, et/ou
- au-dessus de la couche anti-diffusion et en dessous d'au moins une couche d'oxyde, et/ou
- au-dessus de la couche anti-diffusion et en dessous de toutes les couches d'oxyde, et/ou
- au-dessus de la couche anti-diffusion et en dessous de la couche de lissage à base d'oxyde mixte, et/ou
- au-dessus de la couche de lissage à base d'oxyde mixte et en dessous de la couche de mouillage à base d'oxyde de zinc, et/ou
- au-dessus de la couche de mouillage à base d'oxyde de zinc et en dessous de la couche fonctionnelle à base d'argent.

Le revêtement diélectrique situé en-dessous de la couche métallique fonctionnelle à base d'argent peut éventuellement comprendre au moins une couche diélectrique, par exemple à base de nitrure de silicium et/ou d'aluminium, située au-dessus du substrat et en dessous de la couche haut-indice. L'un des rôles de cette couche est d'améliorer l'adhésion de l'empilement de couches minces sur le matériau du substrat. Cette couche a une épaisseur physique comprise entre 5 et 40 nm.

Selon un mode de réalisation, l'invention concerne un matériau comprenant un substrat transparent revêtu d'un empilement de couches minces comprenant une couche métallique fonctionnelle à base d'argent et deux revêtements diélectriques, chaque revêtement diélectrique comportant au moins une couche diélectrique, de manière à ce que la couche métallique fonctionnelle soit disposée entre deux revêtements diélectriques caractérisé en ce que :
un revêtement diélectrique inférieur situé en dessous d'une couche fonctionnelle à base d'argent comprend :
- une couche haut-indice à base d'oxyde métallique, présentant un indice de réfraction supérieur à 2,3 et une épaisseur supérieure à 5 nm,
- une couche anti-diffusion à base de silicium et/ou d'aluminium choisie parmi une couche d'oxyde, de nitrure et d'oxynitrure, située au-dessus et au contact de la couche haut-indice, présentant une épaisseur comprise entre 1 à 10 nm,
- une couche de lissage à base d'oxyde mixte de zinc et d'étain, située au-dessus de la couche anti-diffusion, la couche de lissage étant soit au-contact de la couche antidiffusion ou séparée de la couche anti-diffusion par une couche présentant une épaisseur inférieure à 5 nm, et/ou
- une couche de mouillage à base d'oxyde de zinc, située au-dessus de la couche de lissage et en dessous et, de préférence, au contact d'une couche métallique à base d'argent,
un revêtement diélectrique supérieur situé au-dessus d'une couche fonctionnelle à base d'argent comprenant au moins deux couches minces, chacune d'épaisseur supérieure à 5 nm, dont la différence d'indice de réfraction est supérieure à 0,30.

Selon un autre mode de réalisation, l'invention concerne un matériau comprenant un substrat transparent revêtu d'un empilement de couches minces comprenant une couche métallique fonctionnelle à base d'argent et deux revêtements diélectriques, chaque revêtement diélectrique comportant au moins une couche diélectrique, de manière à ce que la couche métallique fonctionnelle soit disposée entre deux revêtements diélectriques caractérisé en ce que :
un revêtement diélectrique inférieur situé en dessous d'une couche fonctionnelle à base d'argent comprend :
- une couche haut-indice à base d'oxyde métallique, présentant un indice de réfraction supérieur à 2,3 et une épaisseur supérieure à 5 nm,
- une couche anti-diffusion à base de silicium et/ou d'aluminium choisie parmi une couche d'oxyde, de nitrure et d'oxynitrure, située au-dessus et au contact de la couche haut-indice, présentant une épaisseur comprise entre 1 à 10 nm,
- une couche haut-indice présentant une épaisseur inférieure à 5 nm située au-dessus de la couche anti-diffusion et en dessous de la couche fonctionnelle à base d'argent,
- une couche de lissage à base d'oxyde mixte de zinc et d'étain, située au-dessus de la couche anti-diffusion, de préférence au-dessus de la couche haut-indice présentant une épaisseur inférieure à 5 nm, et
- une couche de mouillage à base d'oxyde de zinc, située au-dessus de la couche de lissage et en dessous et au contact d'une couche métallique à base d'argent.

Les revêtements diélectriques supérieurs présentent une épaisseur supérieure à 15 nm, de préférence comprise entre 15 et 100 nm, voire comprise entre 50 et 100 nm ou entre 75 et 100 nm.

Les couches diélectriques des revêtements diélectriques supérieurs présentent les caractéristiques suivantes seules ou en combinaison :
- elles sont déposées par pulvérisation cathodique assistée par champ magnétique, et/ou
- elles sont choisies parmi les oxydes, les nitrures ou les oxynitrures d'un ou plusieurs éléments choisi(s) parmi le titane, le silicium, l'aluminium, le zirconium, l'étain et le zinc,
- elles ont une épaisseur supérieure ou égale à 1 nm, de préférence comprise entre 5 et 100 nm.

De préférence, le revêtement diélectrique supérieur ne forme pas un milieu d'indice de réfraction homogène. Selon ce mode de réalisation, un revêtement diélectrique supérieur comprend au moins deux couches minces, chacune d'épaisseur supérieure à 5 nm, de préférence d'épaisseur supérieure à 10 nm, voire supérieure à 15 nm, dont la différence d'indice de réfraction est, par ordre de préférence croissant supérieure à 0,30, supérieure à 0,50, supérieure à 0,70, supérieure à 0,80.

Le revêtement diélectrique supérieur peut donc comprendre deux couches minces, chacune d'épaisseur supérieure à 5 nm, dont la différence d'indice de réfraction est de préférence comprise entre 0,30 et 1,20.

Selon un mode de réalisation, un revêtement diélectrique supérieur comprend au moins deux couches minces dont la différence d'indice de réfraction entre ces deux couches est : comprise entre 0,7 et 1,20.

Selon un autre mode de réalisation, un revêtement diélectrique supérieur comprend des couches minces d'épaisseur supérieure à 5 nm, de préférence supérieur à 8 nm ou 10 nm, dont la différence d'indice de réfraction entre toutes ces couches est comprise entre 0,30 et 0,65.

Avantageusement, le ou les revêtements diélectriques supérieurs peuvent comprendre au moins une couche à bas indice de réfraction présentant un indice de réfraction inférieur ou égal à 1,7, de préférence inférieur ou égal à 1,6, voire inférieur ou égal à 1,5.

L'épaisseur physique de la couche à bas indice de réfraction du revêtement diélectrique supérieur ou la somme des épaisseurs physiques des couches à bas indice de réfraction du revêtement diélectrique supérieur est, par ordre de préférence croissant supérieure à 5 nm, supérieure à 8 nm, supérieure à 10 nm ou supérieur à 15 nm, supérieure à 40 nm, supérieure à 50 nm, supérieure à 55 nm.

L'épaisseur physique de la couche à bas indice de réfraction du revêtement diélectrique supérieur ou la somme des épaisseurs physiques des couches à bas indice de réfraction du revêtement diélectrique supérieur est, par ordre de préférence croissant inférieure 120 nm, inférieure à 100 nm, inférieure à 80 nm, inférieure à 70 nm.

Les couches à bas indice de réfraction sont préférentiellement des couches d'oxyde de silicium, c'est-à-dire qu'elles sont constituées à plus de 80% en poids d'oxyde de silicium sur la base de la formulation de l'oxyde simple SiO₂, et éventuellement d'au moins un autre élément de préférence choisi dans le groupe constitué par Al, C, N, B, Sn, Zn et de manière très préférée parmi Al, B ou C. De préférence lesdites couches constituées essentiellement d'oxyde de silicium sont constituées à plus de 90% en poids d'oxyde de silicium, sur la base de la formulation de l'oxyde simple SiO₂.

Les couches d'oxyde de silicium sont déposées par pulvérisation cathodique éventuellement assistée par champ magnétique.

Selon un mode de réalisation, un revêtement diélectrique supérieur comprend au moins deux couches minces, chacune d'épaisseur supérieure à 10 nm, dont l'une est une couche à bas indice de réfraction et dont la différence d'indice de réfraction entre ces deux couches est :
- supérieur à 0,3, de préférence supérieur à 0,5, ou
- comprise entre 0,30 et 0,65.

Selon un mode de réalisation, le ou les revêtements diélectriques supérieurs situés au-dessus de la ou des couches métalliques fonctionnelles à base d'argent peuvent comporter au moins une couche haut indice. Cette couche haut indice peut être à base d'oxyde métallique et présenter une épaisseur supérieure à 5 nm. Cette couche haut indice est telle que définie précédemment.

Selon ce mode de réalisation, le revêtement diélectrique supérieur comprend au moins une couche haut-indice à base d'oxyde métallique, présentant un indice de réfraction supérieur à 2,2, de préférence supérieur 2,3, et une épaisseur supérieure à 5 nm, de préférence supérieure à 8 nm, voire supérieure à 10 nm.

L'épaisseur physique de la couche à haut indice de réfraction ou la somme des épaisseurs physiques des couches à haut indice de réfraction située dans le revêtement diélectrique supérieur est comprise entre 10 et 40 nm, de préférence entre 15 et 35 nm.

Le revêtement diélectrique supérieur peut comprendre au moins une couche diélectrique présentant un indice de réfraction inférieur à 2,2, de préférence inférieur à 2,1 et une épaisseur supérieure à 5 nm, de préférence supérieure à 8 nm, voire supérieure à 10 nm. Cette couche est de préférence située au-dessus de la couche haut indice définie ci-dessus.

La couche diélectrique présentant un indice de réfraction inférieur à 2,2, peut être choisie parmi les couches les oxydes, les nitrures ou les oxynitrures d'un ou plusieurs éléments choisi(s) parmi le titane, le silicium, l'aluminium, le zirconium, l'étain et le zinc. De préférence, cette couche est choisie parmi les couches à bas indice de réfraction, les couches à base de nitrure de silicium et/ou d'aluminium et les couches d'oxydes mixtes de zinc et d'étain.

Avantageusement, le ou les revêtements diélectriques supérieurs peuvent comprendre au moins une couche haut indice et une couche à bas indice de réfraction. La couche à bas indice de réfraction est de préférence située au-dessus de la couche à haut indice de réfraction.

La différence d'indice de réfraction entre la ou les couches à haut indice de réfraction et la ou les couches à bas indice de réfraction du revêtement diélectrique supérieur est de préférence comprise entre 0,70 et 1,20, de préférence entre 0,80 et 1,10.

Selon un mode de réalisation avantageux, le revêtement diélectrique supérieur comprend au moins la séquence de couches minces déposées dans l'ordre suivant au-dessus de la couche fonctionnelle:
- au moins une couche à haut indice de réfraction, en matériau d'indice de réfraction supérieur ou égal à 2,20, l'épaisseur physique de la couche à haut indice de réfraction ou la somme des épaisseurs physiques des couches à haut indice de réfraction étant comprise entre 10 et 40 nm,
- au moins une couche à bas indice de réfraction, en matériau d'indice de réfraction inférieur ou égal à 1,70, l'épaisseur physique de la couche à bas indice de réfraction ou la somme des épaisseurs physiques des couches à bas indice de réfraction étant comprise entre 40 et 120 nm.

L'utilisation de cette séquence de couches minces haut et bas indices de réfraction dans le revêtement diélectrique supérieur concourt à l'obtention d'un vitrage présentant un facteur solaire augmenté et une faible variation de couleur en réflexion et en transmission suite à un traitement thermique à température élevée.

Dans le cas où il y a plusieurs couches à haut indice de réfraction dans le revêtement supérieur, les couches à haut indice de réfraction sont de préférence toutes en dessous (en partant du verre) de la ou des couches à bas indice de réfraction et les couches à haut indice de réfraction sont de préférence toutes en contact direct les unes avec les autres. Toutefois, si elles ne sont pas en contact direct les unes avec les autres, elles sont séparées par une couche dont l'indice de réfraction n'est ni inférieur ou égal à 1,70 ni supérieur ou égal à 2,20, l'épaisseur physique de cette (de chacune de ces) couche(s) de séparation étant inférieure ou égale à 30 nm, de préférence inférieure ou égale à 20 nm.

De même, dans le cas où il y a plusieurs couches à bas indice de réfraction dans le revêtement supérieur, les couches à bas indice de réfraction sont de préférence toutes au-dessus (en partant du verre) de la ou des couches à haut indice de réfraction et les couches à bas indice de réfraction sont de préférence toutes en contact direct les unes avec les autres. Toutefois, si elles ne sont pas en contact direct les unes avec les autres, elles sont séparées par une couche dont l'indice de réfraction n'est ni inférieur ou égal à 1,70 ni supérieur ou égal à 2,20, l'épaisseur physique de cette (de chacune de ces) couche(s) de séparation étant inférieure ou égale à 30 nm, de préférence inférieure ou égale à 20 nm.

La couche ou le groupe de couches à haut indice de réfraction du revêtement diélectrique supérieur peut être séparé de la couche ou du groupe de couches à bas indice de réfraction du revêtement diélectrique supérieur par une ou plusieurs autres couches.

Toutefois, de préférence, les couches ou groupes de couches sont en contact direct. Dans le cas où les couches ou groupes de couches ne sont pas en contact direct, les couches ou groupes de couches sont séparées par une couche dont l'indice de réfraction n'est ni inférieur ou égal à 1,70 ni supérieur ou égal à 2,20, l'épaisseur physique de cette couche de séparation étant inférieure ou égale à 30 nm, de préférence inférieure ou égale à 20 nm.

Pour obtenir un facteur solaire élevé et une faible variation des couleurs, il est intéressant que le rapport E de l'épaisseur physique de la couche à bas indice de réfraction ou de la somme des épaisseurs physiques des couches à bas indice de réfraction sur l'épaisseur physique de la couche à haut indice de réfraction ou de la somme des épaisseurs physiques des couches à haut indice de réfraction du revêtement diélectrique supérieur soit compris entre 2,5 et 5,0, de préférence entre 2,5 et 4,0. Lorsque E est compris entre 3,0 et 5,0, la couleur en transmission est plus neutre. Les inventeurs ont également montré que le facteur solaire est maximum lorsque le rapport E est compris entre 2,2 et 4,0.

Le rapport de l'épaisseur physique de la couche à bas indice de réfraction ou de la somme des épaisseurs physiques des couches à bas indice de réfraction sur l'épaisseur physique de la couche à haut indice de réfraction ou de la somme des épaisseurs physiques des couches à haut indice de réfraction du revêtement diélectrique supérieur est compris entre 2,2 et 5,0, de préférence entre 2,5 et 4,0.

Pour obtenir un facteur solaire élevé et des couleurs neutres en transmission, il est également intéressant que le rapport F de l'épaisseur optique totale du revêtement diélectrique supérieur sur l'épaisseur optique totale du revêtement diélectrique inférieur soit compris entre 1,3 et 2,0, de préférence entre 1,5 et 1,8.

Le rapport de l'épaisseur optique totale du revêtement diélectrique supérieur sur l'épaisseur optique totale du revêtement inférieur est, par ordre de préférence croissant, compris entre 1,3 et 2,0 entre 1,4 et 1,9, entre 1,5 et 1,8.

Le revêtement diélectrique supérieur peut comprendre une couche en matériau d'indice de réfraction inférieur ou égal à 2,20 et supérieur ou égal à 1,80, disposée entre la couche métallique fonctionnelle et la couche haut indice de réfraction du revêtement diélectrique supérieur. La couche en matériau d'indice de réfraction inférieur à 2,20 et supérieur ou égal à 1,80 est de préférence à base d'oxyde de zinc, d'oxyde d'étain ou d'oxyde mixte d'étain et de zinc. La couche en matériau d'indice de réfraction inférieur ou égal à 2,20 et supérieur ou égal à 1,80 a une épaisseur physique comprise entre 4 et 15 nm. De préférence cette couche est une couche à base d'oxyde de zinc situé au-dessus de la couche fonctionnelle métallique, de préférence dont l'épaisseur est d'au moins 4 nm, notamment comprise entre 4 et 25 nm et mieux de 5 à 10 nm.

Selon un mode de réalisation avantageux, le revêtement diélectrique supérieur, situé au-dessus de la couche métallique fonctionnelle à base d'argent, comprend :
- une couche à base d'oxyde de zinc,
- une couche haut-indice,
- une couche présentant un indice de réfraction inférieur à 2,2, de préférence, une couche bas indice.

L'empilement de couches minces peut éventuellement comprendre une couche de protection. La couche de protection est de préférence la dernière couche de l'empilement, c'est-à-dire la couche la plus éloignée du substrat revêtu de l'empilement (avant traitement thermique). Ces couches ont en général une épaisseur comprise entre 2 et 10 nm, de préférence 2 et 5 nm. Cette couche de protection peut être choisie parmi une couche de titane, de zirconium, d'hafnium, de zinc et/ou d'étain, ce ou ces métaux étant sous forme métallique, oxydée ou nitrurée.

Selon un mode de réalisation, la couche de protection est à base d'oxyde de zirconium et/ou de titane, de préférence à base d'oxyde de zirconium ou d'oxyde de titane et de zirconium.

Les substrats transparents selon l'invention sont de préférence en un matériau rigide minéral, comme en verre, ou organiques à base de polymères (ou en polymère).

Les substrats transparents organiques selon l'invention peuvent également être en polymère, rigides ou flexibles. Des exemples de polymères convenant selon l'invention comprennent, notamment :
- le polyéthylène,
- les polyesters tels que le polyéthylène téréphtalate (PET), le polybutylène téréphtalate (PBT), le polyéthylène naphtalate (PEN) ;
- les polyacrylates tels que le polyméthacrylate de méthyle (PMMA) ;
- les polycarbonates ;
- les polyuréthanes ;
- les polyamides ;
- les polyimides ;
- les polymères fluorés comme les fluoroesters tels que l'éthylène tétrafluoroéthylène (ETFE), le polyfluorure de vinylidène (PVDF), le polychlorotrifluorethylène (PCTFE), l'éthylène de chlorotrifluorethylène (ECTFE), les copolymères éthylène-propylène fluorés (FEP) ;
- les résines photoréticulables et/ou photopolymérisables, telles que les résines thiolène, polyuréthane, uréthane-acrylate, polyester-acrylate et
- les polythiouréthanes.

Le substrat est de préférence une feuille de verre ou de vitrocéramique.

Le substrat est de préférence transparent, incolore (il s'agit alors d'un verre clair ou extra-clair) ou coloré, par exemple en bleu, gris ou bronze. Le verre est de préférence de type silico-sodo-calcique, mais il peut également être en verre de type borosilicate ou alumino-borosilicate.

Le substrat possède avantageusement au moins une dimension supérieure ou égale à 1 m, voire 2 m et même 3 m. L'épaisseur du substrat varie généralement entre 0,5 mm et 19 mm, de préférence entre 0,7 et 9 mm, notamment entre 2 et 8 mm, voire entre 4 et 6 mm. Le substrat peut être plan ou bombé, voire flexible.

Le matériau, c'est-à-dire le substrat transparent revêtu de l'empilement, est destiné à subir un traitement thermique à température élevée choisi parmi un recuit, par exemple par un recuit flash tel qu'un recuit laser ou flammage, une trempe et/ou un bombage. La température du traitement thermique est supérieure à 300 °C, de préférence supérieure à 400 °C, et mieux supérieure à 500 °C. Le substrat revêtu de l'empilement peut donc être bombé et/ou trempé.

Le matériau peut être sous forme de vitrage monolithique, de vitrage feuilleté ou d'un vitrage multiple notamment un double-vitrage ou un triple vitrage. L'invention concerne donc également un vitrage comprenant au moins un matériau l'invention monté en vitrage monolithique ou en vitrage multiple du type double-vitrage ou vitrage feuilleté. Au moins le substrat revêtu de l'empilement peut être bombé ou trempé.

Un double vitrage est composé d'au moins deux substrats, par exemple des feuilles de verre, séparés deux à deux par une lame de gaz. On désigne ainsi par exemple par la séquence 4/12/4 un double vitrage composé de deux feuilles de verre de 4 mm d'épaisseur et d'une lame de gaz de 12 mm et par 4/12/4/12/4 un triple vitrage composé de trois feuilles de verre de 4 mm d'épaisseur et de deux lames de gaz de 12 mm.

Un double vitrage comporte ainsi 4 faces, la face 1 est à l'extérieur du bâtiment, la face 4 à l'intérieur du bâtiment et les faces 2 et 3 à l'intérieur du double vitrage. De même, un triple vitrage comporte 6 faces, la face 1 est à l'extérieur du bâtiment, la face 6 à l'intérieur du bâtiment, les faces 2 et 3 de chaque côté de la première lame de gaz, à l'intérieur du triple vitrage et les faces 4 et 5 de chaque côté de la deuxième lame de gaz, à l'intérieur du triple vitrage.

Ces matériaux peuvent par ailleurs être intégrés dans des vitrages présentant en outre des fonctionnalités particulières, comme par exemple des vitrages chauffants.

L'invention concerne également un procédé d'obtention d'un matériau comprenant un substrat transparent revêtu d'un empilement de couches minces selon l'invention. Les couches minces sont déposées par pulvérisation cathodique éventuellement assistée par champ magnétique. De préférence, on effectue un traitement thermique à température élevée du type bombage, trempe ou recuit sur ledit substrat. Le procédé peut donc comprendre en outre l'étape pendant laquelle on fait subir un traitement thermique à température élevée du type bombage, trempe ou recuit sur ledit substrat.

Ce traitement thermique peut être réalisé à une température supérieure à 300 °C ou supérieure à 400 °C, de préférence supérieure 500 °C.

Lors d'un traitement de type trempe ou de recuit mis en œuvre dans un four, respectivement de trempe ou de recuisson, l'intégralité du matériau, y compris donc le substrat, est portée à une température élevée, d'au moins 300°C dans le cas de la recuisson, et d'au moins 500°C, voire 600°C, dans le cas d'une trempe.

Le matériau de l'invention convient dans toutes applications nécessitant l'utilisation d'un empilement bas-émissif comprenant des couches d'argent pour lesquelles un facteur solaire élevé, une faible émissivité et bonne transmission lumineuse sont des paramètres clés. Les matériaux selon l'invention conviennent notamment comme matériaux bas émissifs trempables présentant une faible de variation de couleurs suite à un traitement thermique à température élevée ou comme matériaux bas émissifs à tremper présentant un faible flou après trempe.

Les exemples qui suivent illustrent l'invention sans toutefois la limiter.

### Exemples

Plusieurs types d'empilements de couches minces définis ci-après sont déposés sur des substrats en verre sodo-calcique clair d'une épaisseur de 3,9 mm, de manière connue, sur une ligne de pulvérisation cathodique (procédé magnétron) dans laquelle le substrat vient défiler sous différentes cibles.

Les exemples Inv.1, Inv.1', Inv.1 ", Inv.4, Inv.5 and Inv.6 ne sont pas selon la revendication indépendante 1.

Pour ces exemples, les conditions de dépôt des couches déposées par pulvérisation (pulvérisation dite « cathodique magnétron ») sont résumées dans le tableau 1 ci-dessous.

| **Tableau 1** | Cibles employées | Pression dépôt | Gaz | Indice |
|---|---|---|---|---|
| Si₃N₄ | Si:Al (92:8 % en pds) | 2-15*10⁻³ mbar | Ar 47 % - N₂ 53 % | 2,00 |
| ZrO₂ | ZrO₂ | 8*10⁻³ mbar | Ar 90 % - O₂ 10 % | 2,1 |
| SiZrAIN | Si:Al:Zr (70:8:22% at.) | 2.10⁻³ mbar | Ar 55 % - N₂ 45 % | 2,22 |
| SnZnOx | Sn:Zn (60:40% en pds) | 1,5*10⁻³ mbar | Ar 39 % - O₂ 61 % | 2,09 |
| ZnO | ZnAlO (98:2 % en pds) | 1,5*10⁻³ mbar | Ar 91 %-O₂ 9% | 2,04 |
| Ag | Ag | 8*10⁻³ mbar | Ar à 100 % | - |
| NiCr | Ni:Cr (80 : 20% at.) | 2*10⁻³ mbar | Ar à 100 % | - |
| SiO₂ | Si:Al (92:8 % en pds) | 2-5*10⁻³ mbar | Ar 70 % - O₂ 30% | 1,55 |
| TiO₂ | TiOx | 1,5.10₋₃ mbar | Ar 88 % - O₂ 12% | 2,32 |

| | | | | |
|---|---|---|---|---|
| at. : atomique ; pds : poids ; Indice : à 550 nm. | | | | |

Le tableau 1 indique pour chaque matériau testé l'épaisseur physique des couches de l'empilement, exprimée en nm (sauf autres indications). La première ligne correspond à la couche la plus éloignée du substrat, en contact avec l'air libre.

Les matériaux munis de l'empilement sont soumis à un traitement thermique de type trempe consistant notamment en un chauffage à 620°C pendant 10 minutes.

### I. Evaluation du caractère appariable

Le caractère appariable selon l'invention se caractérise par l'absence de variation avant et après traitement thermique :
- de la diffusion se traduisant par l'absence de flou ou de défauts,
- des couleurs.

Pour chaque matériau décrit dans les tableaux 2 et 3, des observations permettant d'évaluer, le flou, les défauts et les variations colorimétriques ont été reportées.

Ces évaluations rendent comptes de variations dues au traitement thermique à température élevée.

### 1. Evaluation de la diffusion par mesure du flou

Les phénomènes de diffusion de la lumière se traduisent visuellement par l'apparition d'un halo lumineux appelé « flou », visible généralement sous lumière intense.

Le flou a été apprécié visuellement par un panel de plusieurs personnes qui constate la présence ou non d'un voile blanc ou halo lumineux apparaissant après traitement thermique. Le panel a attribué pour chaque vitrage un indicateur d'appréciation choisi parmi :
«-» présence d'un voile blanc marqué traduisant une forte diffusion,
«0» léger voile blanc traduisant une faible diffusion,
«+» absence de voile blanc traduisant l'absence de diffusion.

Le flou (« haze ») correspond à la quantité de la lumière transmise qui est diffusée à des angles de plus de 2,5°. Ce flou peut également être évalué par mesure de la réflexion diffuse visible moyenne au spectromètre Perkin-Elmer L900. La mesure consiste à faire la moyenne de la partie diffusée de la réflexion sur le domaine du visible, en excluant la réflexion spéculaire de la mesure et en soustrayant la ligne de base prise sur un échantillon de référence non flou. Il s'exprime en pourcentage par rapport à une réflexion totale mesurée sur un miroir de référence.

### 2. Evaluation de la présence de défauts dans la couche d'argent

L'analyse par microscopie optique ou par microscopie électronique à balayage permet de mettre en évidence la présence de défauts après traitement thermique.

Les appréciations suivantes ont rapportées après observation microscopique :
«-» : Présence de nombreux défauts dans la couche d'argent,
«0» : Présence de quelques défauts dans la couche d'argent,
«+» : Absence de défaut,
« X » : Pas d'information disponible.

Enfin, le type de défaut est qualifié de la façon suivante :
- « D » : défaut de type « dôme »,
- « T » : défaut de type « trou »,
- « 0 » : Pas de défaut visible,
- « X » : Pas d'information disponible.

### 3. Evaluation de variations colorimétriques

Les variations colorimétriques en transmission et en réflexion avant et après traitement thermique ont été évaluées visuellement par un panel de plusieurs personnes. Le panel a attribué pour chaque vitrage un indicateur d'appréciation choisi parmi :
«-» : variations de couleur visible à l'œil rendant le matériau non appariable,
«0» : légères variations de couleur ne rendant pas le matériau non appariable,
«+» : pas de variation de couleur visible à l'œil, matériau appariable.

| **Tableau 2 : Vitrage** | | **Cp.0** | **Cp.1** | **Cp.2** | **Cp.2'** | **Cp.2"** | **Cp.2"'** | **Cp.3** | **Cp.3'** | **Cp.3"** |
|---|---|---|---|---|---|---|---|---|---|---|
| Couche protectrice | ZrO₂ | 2,5 | 2,5 | 2,5 | 2,5 | 2,5 | 2,5 | 2,5 | 2,5 | 2,5 |

| RD supérieur | | | | | | | | | | |
|---|---|---|---|---|---|---|---|---|---|---|
| - Couche diélectrique | Si3N4 | 37 | - | 37 | 37 | 37 | 20 | - | - | - |
| | SnZnO | - | - | - | - | - | 17 | - | - | - |
| - Couche bas indice | SiO₂ | - | 62 | - | - | - | - | 60 | 60 | 62 |
| - Couche haut-indice | TiOx | - | 20 | - | - | - | - | 20 | 20 | 20 |
| - Couche diélectrique | ZnO | 7 | 7 | 5 | 5 | 5 | 5 | 5 | 5 | 7 |
| Couche de blocage | Nicr | 0,5 | 0,5 | 1 | 1 | 1 | 1 | 1 | 1 | 0,5 |
| Couche fonctionnelle | Ag | 9,2 | 9,2 | 9 | 9 | 9 | 9 | 9 | 9 | 9,2 |

| RD inférieur | | | | | | | | | | |
|---|---|---|---|---|---|---|---|---|---|---|
| - Couche de mouillage | ZnO | 6 | 6 | 5 | - | 5 | 5 | 5 | - | 6 |
| - Couche de lissage | SnZnO | 23 | 23 | - | 10 | 10 | 10 | - | 10 | 18 |
| - couche intermédiaire | TiOx | - | - | - | - | - | - | - | - | - |
| - Couche anti-diffusion | SiZrN | - | - | - | - | - | - | - | - | - |
| | Si₃N₄ | - | - | - | - | - | - | - | - | - |
| - Couche haut indice | TiOx | 2 | 2 | 10 | 10 | 10 | 10 | 10 | 10 | 10 |
| - Couche diélectrique | Si₃N₄ | 6 | 6 | 5 | 5 | 5 | 5 | 5 | 5 | 6 |
| Substrat (mm) | verre | 3,9 | 3,9 | 3,9 | 3,9 | 3,9 | 3,9 | 3,9 | 3,9 | 3,9 |

| **Observations** | | | | | | | | | | |
|---|---|---|---|---|---|---|---|---|---|---|
| Colorimétrie | | + | + | + | + | + | + | - | - | - |
| Diffusion | | + | + | 0 | 0 | 0 | 0 | - | - | - |
| Défauts visuels | | 0 | - | 0 | 0 | 0 | 0 | - | X | - |
| Type de défaut | | D | X | T | D | D | D | T | X | T |

| **Tableau 3** : **Vitrage** | | **Inv.1** | **Inv.1'** | **Inv.1"** | **Inv.2** | **Inv.2'** | **Inv**.**2"** | **Inv.4** | **Inv.4'** | **Inv.5** | **Inv.5'** | **Inv. 6** | **Inv. 6'** | **Inv.7** |
|---|---|---|---|---|---|---|---|---|---|---|---|---|---|---|
| Couche protectrice | - | - | - | - | - | - | - | - | - | - | - | - | - | - |
| RD supérieur | | | | | | | | | | | | | | |
| - Couche diélectrique | Si3N4 | - | - | - | - | - | - | - | - | - | - | - | - | 37 |
| - Couche bas indice | SnZnO | - | - | - | - | - | - | 37 | 37 | - | - | - | - | - |
| | SiO₂ | 60 | 60 | 60 | 60 | 60 | 60 | - | - | 60 | 60 | - | - | - |
| - Couche haut-indice | TiOx | 20 | 20 | 20 | 20 | 20 | 20 | 20 | 20 | - | - | 20 | 20 | 20 |
| - Couche diélectrique | ZnO | 5 | 5 | 5 | 5 | 5 | 5 | 5 | 5 | 5 | 5 | 5 | 5 | 5 |
| Couche de blocage | Nicr | 1 | 1 | 1 | 1 | 1 | 1 | 1 | 1 | 1 | 1 | 1 | 1 | 1 |
| Couche fonctionnelle | Ag | 9 | 9 | 9 | 9 | 9 | 9 | 9 | 9 | 9 | 9 | 9 | 9 | 9 |

| RD inférieur | | | | | | | | | | | | | | |
|---|---|---|---|---|---|---|---|---|---|---|---|---|---|---|
| - Couche de mouillage | ZnO | 5 | - | 5 | 5 | - | 5 | 5 | 5 | 5 | 5 | 5 | 5 | 5 |
| - Couche de lissage | SnZnO | - | 10 | 10 | - | 10 | 10 | 10 | 10 | 10 | 10 | 10 | 10 | 10 |
| - couche intermédiaire | TiOx | - | - | - | 2-3 | 2-3 | 2-3 | - | 2-3 | - | 2-3 | - | 2-3 | 2-3 |
| - Couche anti-diffusion | SiZrN | 3 | 3 | 3 | - | - | - | - | - | - | - | - | - | - |
| | Si₃N₄ | - | - | - | 3 | 3 | 3 | 3 | 3 | 3 | 3 | 3 | 3 | 3 |
| - Couche haut indice | TiOx | 10 | 10 | 10 | 10 | 10 | 10 | 10 | 10 | 10 | 10 | 10 | 10 | 10 |
| - Couche diélectrique | Si₃N₄ | 5 | 5 | 5 | 5 | 5 | 5 | 5 | 5 | 5 | 5 | 5 | 5 | 5 |
| Substrat (mm) | verre | 3,8 | 3,8 | 3,8 | 3,8 | 3,8 | 3,8 | 3,8 | 3,8 | 3,8 | 3,8 | 3,8 | 3,8 | 3,8 |

| **Observations** | | | | | | | | | | | | | | |
|---|---|---|---|---|---|---|---|---|---|---|---|---|---|---|
| Colorimétrie | | + | + | + | + | + | + | + | + | + | + | + | + | + |
| Diffusion | | 0 | 0 | 0 | + | + | + | 0 | + | 0 | + | 0 | + | + |
| Défauts visuels | | 0 | 0 | 0 | + | + | + | 0 | 0 | 0 | 0 | 0 | + | + |
| Type de défaut | | D | X | D | X | X | 0 | X | X | X | X | X | X | X |

Ces exemples montrent que l'on n'observe pas de diffusion visible à l'œil :
- en l'absence d'une couche haut indice ou d'une séquence de couches haut et bas indices dans le revêtement diélectrique supérieur et en l'absence d'une couche haut indice d'épaisseur supérieure à 5 nm dans le revêtement diélectrique inférieur (Cp.0),
- en présence d'une séquence de couches haut et bas indices dans le revêtement diélectrique supérieur, sans couche haut indice d'épaisseur supérieure à 5 nm dans le revêtement diélectrique inférieur (Cp.1).

Pour cela, on peut se baser sur Cp.0 et Cp.1 en comparaison à Cp.3".

Les variations significatives de propriétés optiques et colorimétriques sont observées que lorsque :
- le revêtement diélectrique inférieur comporte une couche haut indice de plus de 10 nm et
- le revêtement diélectrique supérieur d'indice de réfraction non homogène comporte des couches d'indices de réfraction différents.

Les revêtements diélectriques d'indices de réfraction non homogènes peuvent être respectivement constitués d'une séquence de couches d'indices différents, de préférence à base d'oxyde telle que :
- d'une couche haut indice de TiO2 et d'une couche bas indice de SiO₂,
- d'une couche haut indice et d'une couche de SnZnOx,
- d'une couche de ZnO et d'une couche de SiO₂,
- d'une couche de ZnO et d'une couche de TiO₂.

Pour cela, on peut comparer :
- l'exemple Cp.2 (peu de diffusion et pas de variation de couleur) à l'exemple Cp.3 (diffusion et variation de couleur),
- l'exemple Cp.2' (peu de diffusion et pas de variation de couleur) à l'exemple Cp.3' (diffusion et variation de couleur),
- l'exemple Cp.2" (peu de diffusion et pas de variation de couleur) à l'exemple Cp.3" (diffusion et variation de couleur).

La solution de l'invention consistant à ajouter une couche anti-diffusion par exemple à base de nitrure de silicium et/ou d'aluminium, située au-dessus de la couche haut indice et en dessous de la couche d'oxyde permet de diminuer le flou (amélioration de la diffusion de « - » à « 0 ») et les variations colorimétriques suite à un traitement thermique à température élevée (amélioration de la colorimétrie de « - » à « + »). Quelques défauts dans la couche d'argent demeurent observables.

La solution encore plus avantageuse consistant à ajouter à la fois une couche anti-diffusion et une couche intermédiaire haut indice présentant une épaisseur inférieure à 5 nm située au-dessus de la couche anti-diffusion et en dessous de la couche fonctionnelle à base d'argent permet d'améliorer en plus la qualité de la couche d'argent (amélioration de la diffusion de « - » à « + » et diminution des défauts).

Pour cela, on peut comparer :
- l'exemple Cp.3 aux exemples Inv.1 et Inv.2,
- l'exemple Cp.3' aux exemples Inv.1' et Inv.2',
- l'exemple Cp.3" aux exemples Inv.1" et Inv.2".

Le tableau 4 regroupe certains exemples afin de faciliter la compréhension des avantages de l'invention. Les exemples Inv.1, Inv.1' et Inv.1" ne sont pas selon la revendication indépendante 1.

| **Tableau 4 : Vitrage** | | **Cp.3** | **Inv.1** | **Inv.2** | **cp.3'** | **Inv.1'** | **Inv.2'** | **cp.3"** | **Inv.1"** | **Inv**.**2"** |
|---|---|---|---|---|---|---|---|---|---|---|
| Couche protectrice | ZrO2 | 2,5 | - | - | 2,5 | - | | 2,5 | - | - |
| RD supérieur | | | | | | | | | | |
| - Couche diélectrique | Si3N4 | - | - | - | - | - | - | - | - | - |
| | SnZnO | - | - | - | - | - | - | - | - | - |
| - Couche bas indice | SiO₂ | 60 | 60 | 60 | 60 | 60 | 60 | 62 | 60 | 60 |
| - Couche haut-indice | TiOx | 20 | 20 | 20 | 20 | 20 | 20 | 20 | 20 | 20 |
| - Couche diélectrique | ZnO | 5 | 5 | 5 | 5 | 5 | 5 | 7 | 5 | 5 |
| Couche de blocage | Nicr | 1 | 1 | 1 | 1 | 1 | 1 | 0,5 | 1 | 1 |
| Couche fonctionnelle | Ag | 9 | 9 | 9 | 9 | 9 | 9 | 9,2 | 9 | 9 |

| RD inférieur | | | | | | | | | | |
|---|---|---|---|---|---|---|---|---|---|---|
| - Couche de mouillage | ZnO | 5 | 5 | 5 | - | - | - | 6 | 5 | 5 |
| - Couche de lissage | SnZnO | - | - | - | 10 | 10 | 10 | 18 | 10 | 10 |
| - couche intermédiaire | TiOx | - | - | 2-3 | - | - | 2-3 | - | - | 2-3 |
| - Couche anti-diffusion | SiZrN | - | 3 | - | - | 3 | - | - | 3 | - |
| | Si₃N₄ | - | - | 3 | - | - | 3 | - | - | 3 |
| - Couche haut indice | TiOx | 10 | 10 | 10 | 10 | 10 | 10 | 10 | 10 | 10 |
| - Couche diélectrique | Si₃N₄ | 5 | 5 | 5 | 5 | 5 | 5 | 6 | 5 | 5 |
| Substrat (mm) | verre | 3,9 | 3,8 | 3,8 | 3,9 | 3,8 | 3,8 | 3,9 | 3,8 | 3,8 |

| **Observations** | | | | | | | | | | |
|---|---|---|---|---|---|---|---|---|---|---|
| Colorimétrie | | - | + | + | - | + | + | - | + | + |
| Diffusion | | - | 0 | + | - | 0 | + | - | 0 | + |
| Défauts visuels | | - | 0 | + | X | 0 | + | - | 0 | + |
| Type de défaut | | T | D | X | X | X | X | T | D | 0 |

### II. Etude du phénomène d'inter-diffusion

Pour montrer le phénomène d'inter-diffusion entre la couche haut indice et la couche d'oxyde telle que la couche de lissage, les profils de l'élément titane dans le matériau comparatif Cp.3" et dans le matériau selon l'invention Inv.1" ont été déterminés. Les graphiques illustrant ces profils de concentrations sont obtenus par SIMS « Secondary Ion Mass Spectrometry » et représente en abscisse une mesure de profondeur P correspondant au décapage ionique et en ordonnée la concentration correspondant à l'élément titane analysé en unités arbitraires.

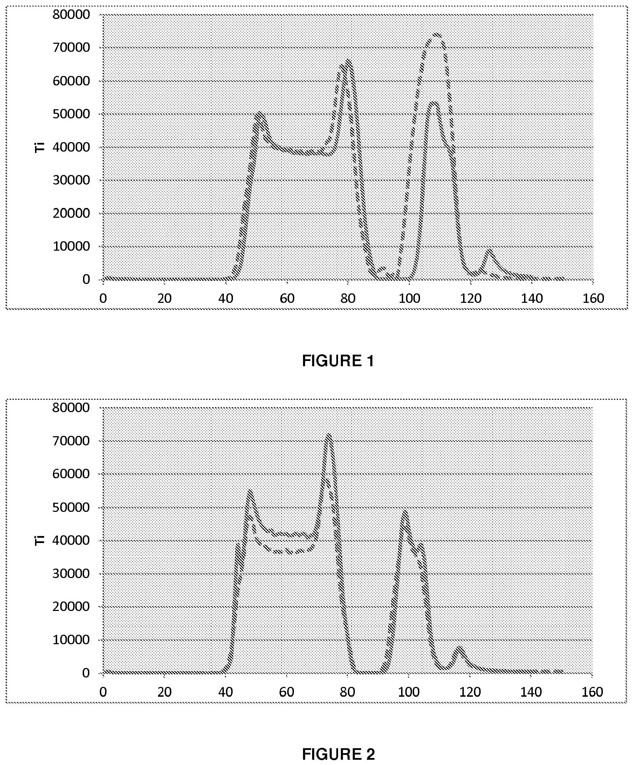

La figure 1 représente pour le matériau comparatif cp.3", le profil de l'élément titane avant (courbe avec trait continu) et après (courbe avec trait pointillé) traitement thermique de type trempe. On observe nettement la migration du titane de la couche haut indice vers la couche de lissage correspondant à un décalage de la courbe obtenue après traitement thermique par rapport à la courbe obtenue avant traitement thermique vers la gauche.

La figure 2 représente pour un matériau selon l'invention Inv.1", le profil de l'élément titane avant (Courbe avec trait continu) et après traitement thermique de type trempe (Courbe avec trait pointillé). On n'observe pas de migration nette du titane dans la couche de lissage. Les deux courbes ne sont pas significativement décalées. La couche anti-diffusion à base de nitrure de silicium et de zirconium empêche bien la migration du titane de la couche haut indice vers la couche de lissage.

### III. Performances optiques

Les caractéristiques suivantes ont été mesurées et regroupées dans le tableau ci-dessous :
- TL indique la transmission lumineuse dans le visible en %, mesurée selon l'illuminant D65 à 2° Observateur ;
- TE correspond à la transmission énergétique ;
- RE correspond à la réflexion énergétique,
- g correspond au facteur solaire ;
- L*T, a*T et b*T indiquent les couleurs en transmission L*, a* et b* dans le système L*a*b* mesurées selon l'illuminant D65 à 2°, observateur du côté de l'empilement et mesurées ainsi perpendiculairement au vitrage,
- RL indique la réflexion lumineuse dans le visible en %, mesurée selon l'illuminant D65 à 2° Observateur du côté de l'empilement ou du côté du substrat correspondant au côté opposé à celui de l'empilement ;
- L*R, a*R et b*R indiquent les couleurs en réflexion L*, a* et b* dans le système L*a*b* mesurées selon l'illuminant D65 à 2°, observateur du côté de l'empilement ou du côté du substrat et mesurées ainsi perpendiculairement au vitrage,
- ΔE représente la variation entre les valeurs L*, a* et b* obtenues pour un substrat revêtu avant et après avoir subi un traitement thermique. La variation est calculée de la façon suivante : ΔE = (Δa*2 + Δb*2 + ΔL*2)^{½}.

Ces caractéristiques sont mesurées pour un matériau muni de l'empilement d'abord en sortie de la ligne magnétron puis après traitement thermique de type trempe.

| | | **Transmission** | | | | | | **g** |
|---|---|---|---|---|---|---|---|---|
| | | **TL** | **TE** | **L*T** | **a*L** | **b*L** | **ΔEL** | |
| Cp.0 | BT | 86,8 | 68,1 | 94,6 | -1,2 | 1,1 | 0,5 | 0,70 |
| | AT | 88,2 | 68,9 | 94,8 | -0,6 | 1,9 | | 0,70 |
| Cp.0 | BT | 88 | 69,7 | 95,2 | -1,5 | 2,1 | 1,2 | - |
| | AT | 90,3 | 71,6 | 96,1 | -0,9 | 1,6 | | - |
| Cp.3" | BT | 85,4 | 69,2 | 94,1 | -1,8 | 2,6 | 1,0 | - |
| | AT | 85,8 | 70,2 | 94,2 | -1,1 | 0,7 | | - |
| Cp.3" | BT | 84 | - | 93,4 | -1,3 | 1,1 | 2,2 | - |
| | AT | 85,6 | - | 94,1 | -0,8 | -0,9 | | - |
| Inv.1" | BT | 82,6 | - | 92,8 | -1,4 | 1,4 | 1,0 | - |
| | AT | 83,7 | - | 93,3 | -1,8 | 2,2 | | - |
| Inv.2" | BT | 86,8 | 68,1 | 94,7 | -2,6 | 3,7 | 1,2 | 0,705 |
| | AT | 89,4 | 69,3 | 95,8 | -3 | 4,1 | | 0,698 |

| | | | | | | | | |
|---|---|---|---|---|---|---|---|---|
| BT : Avant traitement thermique, AT : après traitement thermique. | | | | | | | | |

| | | **Réflexion côté empilement** | | | | | | **Réflexion côté verre** | | | | | |
|---|---|---|---|---|---|---|---|---|---|---|---|---|---|
| | | **RL** | **RE** | **LR** | **a*R** | **b*R** | **ΔER** | **RL** | **RE** | **LR** | **a*R** | **b*R** | **ΔER** |
| Cp.0 | BT | 4,8 | 19,2 | **26,2** | 0,9 | -9,2 | 2,1 | 6,6 | 16,5 | **30,8** | -1,0 | -7,3 | 2,1 |
| | AT | 5,5 | 19,8 | **29,3** | -2,6 | -10,1 | | 7,7 | 17,2 | **33,3** | -3,6 | -8,1 | |
| Cp.0 | BT | 5,1 | 18,6 | 27,1 | 0,6 | -8,2 | 2,1 | 6,4 | 16,4 | 30,5 | -0,1 | -8,6 | 1,4 |
| | AT | 5,4 | 20,1 | 27,7 | -1,4 | -8,5 | | 6,2 | 17,6 | 29,9 | -1,4 | -8,5 | |
| Cp.3" | BT | 6,5 | 16,4 | **30,7** | 2,7 | -11,1 | 6,4 | 8,3 | 15,9 | **34,5** | 2,5 | 4,3 | 4,9 |
| | AT | 7,7 | 17 | **32,7** | -0,3 | -0,4 | | 9,3 | 16,2 | **36,5** | -0,5 | 4,1 | |
| Cp.3" | BT | 8,7 | - | 35,4 | 1 | -3,6 | 8,5 | 10,2 | - | 38,2 | 1,1 | 1,1 | 4,8 |
| | AT | 10,1 | - | 37,9 | -0,4 | 4,4 | | 10,9 | - | 39,5 | -0,3 | 5,5 | |
| Inv.1" | BT | 8,7 | - | 35,4 | 0,8 | 4,6 | 2,6 | 10,1 | - | 37,9 | 1,0 | 0,7 | 0,8 |
| | AT | 10,1 | - | 38 | 1 | 4,4 | | 10,4 | - | 38,5 | 0,4 | 0,7 | |
| Inv.2" | BT | 4,4 | 18,6 | 24,9 | 8,2 | -16,8 | 0,9 | 5,5 | 15,3 | 28,1 | 5,9 | -15,2 | 2,6 |
| | AT | 4,6 | 19,7 | 25,6 | 8,6 | -16,4 | | 5,2 | 16 | 27,4 | 5,9 | -12,7 | |

Ces exemples montrent que l'on n'observe :
- peu de variations colorimétriques en l'absence d'une séquence de couches haut et bas indices dans le revêtement diélectrique supérieur et en l'absence d'une couche haut indice d'épaisseur supérieure à 5 nm dans le revêtement diélectrique inférieur (Cp.0),
- des variations significatives en présence d'une séquence de couches haut et bas indice dans le revêtement diélectrique supérieur et en présence d'une couche haut indice d'épaisseur supérieure à 5 nm dans le revêtement diélectrique inférieur (Cp.3"),

Ces variations colorimétriques sont largement réduites grâce à la couche d'antidiffusion à base de nitrure de silicium notamment un ΔE en réflexion :
- côté empilement qui diminue de plus de 6 (cp.3") à 2,6 (Inv.1") ou 0,9 (Inv.2")
- côté verre qui diminue d'environ 5 (cp.3") à 0,8 (Inv.1") ou 2,6 (Inv.2")

L'exemple selon l'invention 1" présente une transmission lumineuse élevée et de faibles variations colorimétriques.

L'exemple selon l'invention 2" comprenant à la fois la couche anti-difusion et la couche intermédiaire présente une transmission lumineuse encore plus élevée, de faibles variations colorimétriques et un facteur solaire très élevé.

## Revendications

1. Matériau comprenant un substrat transparent revêtu d'un empilement de couches minces comprenant une couche métallique fonctionnelle à base d'argent et deux revêtements diélectriques, chaque revêtement diélectrique comportant au moins une couche diélectrique, de manière à ce que la couche métallique fonctionnelle soit disposée entre deux revêtements diélectriques **caractérisé en ce qu'**un revêtement diélectrique inférieur situé en dessous d'une couche fonctionnelle à base d'argent comprend :
- une couche haut-indice à base d'oxyde métallique, présentant un indice de réfraction supérieur à 2,3 et une épaisseur supérieure à 5 nm,
- une couche anti-diffusion à base de silicium et/ou d'aluminium choisie parmi une couche d'oxyde, de nitrure et d'oxynitrure, située au-dessus de la couche haut-indice, présentant une épaisseur comprise entre 1 à 10 nm,
- une couche haut indice présentant une épaisseur inférieure à 5 nm située au-dessus de la couche anti-diffusion et en dessous de la couche fonctionnelle à base d'argent,
- au moins une couche à base d'oxyde située au-dessus de la couche anti-diffusion et présentant une composition différente de la couche anti-diffusion.

2. Matériau selon la revendication 1 **caractérisé en ce qu'**un revêtement diélectrique supérieur situé au-dessus d'une couche fonctionnelle à base d'argent comprend au moins deux couches minces, chacune d'épaisseur supérieure à 5 nm, dont la différence d'indice de réfraction est supérieure à 0,30.

3. Matériau selon l'une quelconque des revendications précédentes **caractérisé en ce que** la couche anti-diffusion est située au-dessus et au contact de la couche haut indice présentant une épaisseur supérieure à 5 nm.

4. Matériau selon l'une quelconque des revendications précédentes **caractérisé en ce que** la somme des épaisseurs des couches à base d'oxyde situées au-dessus de la couche anti-diffusion dans le revêtement diélectrique inférieur est supérieure à 5,0 nm.

5. Matériau selon l'une quelconque des revendications précédentes **caractérisé en ce que** au moins une couche à base d'oxyde située au-dessus de la couche anti-diffusion et présentant une composition différente du revêtement diélectrique inférieur est une couche de mouillage à base d'oxyde de zinc, située de préférence directement au contact de la couche métallique à base d'argent.

6. Matériau selon l'une quelconque des revendications précédentes **caractérisé en ce que** le revêtement diélectrique situé en dessous de la couche fonctionnelle à base d'argent comprend comme couches à base d'oxyde :
- une couche de lissage à base d'oxyde mixte, située au-dessus de la couche anti-diffusion et présentant une composition différente, la couche de lissage étant soit au-contact de la couche anti-diffusion ou séparée de la couche anti-diffusion par une couche présentant une épaisseur inférieure à 5 nm, et
- une couche de mouillage à base d'oxyde de zinc, située au-dessus de la couche de lissage.

7. Matériau selon l'une quelconque des revendications précédentes **caractérisé en ce que** les couches haut-indice à base d'oxyde métallique sont choisies parmi les couches d'oxyde de titane, d'oxyde de niobium ou les couches d'un alliage obtenu à partir de titane et de niobium.

8. Matériau selon l'une quelconque des revendications précédentes **caractérisé en ce que** la couche anti-diffusion est choisie parmi les couches :
- d'oxyde de silicium, d'oxyde d'aluminium et d'oxyde de silicium et d'aluminium,
- de nitrure de silicium, de nitrure d'aluminium, de nitrure de silicium et d'aluminium, de nitrures de silicium et de zirconium,
- d'oxynitrures de silicium, d'oxynitrures d'aluminium et d'oxynitrures de silicium et d'aluminium.

9. Matériau selon l'une quelconque des revendications précédentes **caractérisé en ce que** la couche de lissage est une couche d'oxyde mixte comprenant un ou plusieurs métaux choisis parmi l'étain Sn, le zinc Zn, le gallium Ga et l'indium In.

10. Matériau selon l'une quelconque des revendications précédentes, **caractérisé en ce que** le revêtement diélectrique supérieur comprend au moins une couche haut-indice à base d'oxyde métallique, présentant un indice de réfraction supérieur à 2,3 et une épaisseur supérieure à 5 nm.

11. Matériau selon l'une quelconque des revendications précédentes, **caractérisé en ce que** le revêtement diélectrique supérieur comprend au moins une couche diélectrique présentant un indice de réfraction inférieur à 2,2 et une épaisseur supérieure à 5 nm situé au-dessus de la couche haut indice.

12. Matériau selon l'une quelconque des revendications précédentes, **caractérisé en ce que** le revêtement diélectrique supérieur comprend au moins une couche à bas indice de réfraction présentant un indice de réfraction inférieur ou égal à 1,7 et une épaisseur supérieure à 5 nm.

13. Matériau selon l'une quelconque des revendications précédentes, **caractérisé en ce que** le revêtement diélectrique supérieur comprend au moins la séquence de couches minces déposées dans l'ordre suivant au-dessus de la couche fonctionnelle:
- au moins une couche à haut indice de réfraction, en matériau d'indice de réfraction supérieur ou égal à 2,20, l'épaisseur physique de la couche à haut indice de réfraction ou la somme des épaisseurs physiques des couches à haut indice de réfraction étant comprise entre 10 et 40 nm,
- au moins une couche à bas indice de réfraction, en matériau d'indice de réfraction inférieur ou égal à 1,70, l'épaisseur physique de la couche à bas indice de réfraction ou la somme des épaisseurs physiques des couches à bas indice de réfraction étant comprise entre 40 et 120 nm.

14. Matériau selon l'une quelconque des revendications précédentes tel que le substrat est en verre, notamment silico-sodo-calcique ou en matière organique polymérique.

15. Procédé d'obtention d'un matériau comprenant un substrat transparent revêtu d'un empilement de couches minces selon l'une quelconque des revendications 1 à 14, les couches minces étant déposées par pulvérisation cathodique éventuellement assistée par champ magnétique **caractérisé en ce que** l'on effectue un traitement thermique à température élevée du type bombage, trempe ou recuit sur ledit substrat.

## Patentansprüche

1. Material, umfassend ein transparentes Substrat, das mit einem Stapel aus dünnen Schichten beschichtet ist, umfassend eine metallische Funktionsschicht auf Basis von Silber und zwei dielektrische Beschichtungen, wobei jede dielektrische Beschichtung mindestens eine dielektrische Schicht beinhaltet, sodass jede metallische Funktionsschicht zwischen zwei dielektrischen Beschichtungen angebracht ist, **dadurch gekennzeichnet, dass** eine unterhalb einer metallischen Funktionsschicht auf Basis von Silber angeordnete untere dielektrische Beschichtung Folgendes umfasst:
- eine Hochindexschicht auf Basis von Metalloxid, die einen Brechungsindex größer als 2,3 und eine Dicke größer als 5 nm aufweist,
- eine Antidiffusionsschicht auf Basis von Silicium und/oder Aluminium, ausgewählt aus einer Oxid-, Nitrid- und Oxynitridschicht, angeordnet oberhalb der Hochindexschicht, die eine Dicke zwischen 1 bis 10 nm aufweist,
- eine Hochindexschicht, die eine Dicke kleiner als 5 nm aufweist, angeordnet oberhalb der Antidiffusionsschicht und unterhalb der Funktionsschicht auf Basis von Silber,
- mindestens eine Schicht auf Basis von Oxid, angeordnet oberhalb der Antidiffusionsschicht und eine von der Antidiffusionsschicht verschiedene Zusammensetzung aufweisend.

2. Material nach Anspruch 1, **dadurch gekennzeichnet, dass** eine oberhalb der Funktionsschicht auf Basis von Silber angeordnete obere dielektrische Beschichtung mindestens zwei dünne Schichten umfasst, jede von einer Dicke größer als 5 nm, von denen der Unterschied des Brechungsindexes größer ist als 0,30.

3. Material nach einem der vorstehenden Ansprüche, **dadurch gekennzeichnet, dass** die Antidiffusionsschicht oberhalb und in Kontakt mit der Hochindexschicht angeordnet ist, die eine Dicke größer als 5 nm aufweist.

4. Material nach einem der vorstehenden Ansprüche, **dadurch gekennzeichnet, dass** die Summe der Dicken der Schichten auf Basis von Oxid, die oberhalb der Antidiffusionsschicht in der unteren dielektrischen Beschichtung angeordnet sind, größer als 5,0 nm ist.

5. Material nach einem der vorstehenden Ansprüche, **dadurch gekennzeichnet, dass** mindestens eine Schicht auf Basis von Oxid, angeordnet oberhalb der Antidiffusionsschicht und eine von der unteren dielektrischen Beschichtung verschiedene Zusammensetzung aufweisend, eine Benetzungsschicht auf Basis von Zinkoxid ist, vorzugsweise direkt in Kontakt mit der Metallschicht auf Basis von Silber angeordnet.

6. Material nach einem der vorstehenden Ansprüche, **dadurch gekennzeichnet, dass** die unterhalb der Funktionsschicht auf Basis von Silber angeordnete dielektrische Beschichtung als Schichten auf Basis von Oxid Folgendes umfasst:
- eine Glättungsschicht auf Basis von gemischtem Oxid, angeordnet oberhalb der Antidiffusionsschicht und eine unterschiedliche Zusammensetzung aufweisend, wobei die Glättungsschicht entweder mit der Antidiffusionsschicht in Kontakt ist oder von der Antidiffusionsschicht durch eine Schicht getrennt ist, die eine Dicke kleiner als 5 nm aufweist, und
- eine oberhalb der Glättungsschicht angeordnete Benetzungsschicht auf Basis von Zinkoxid.

7. Material nach einem der vorstehenden Ansprüche, **dadurch gekennzeichnet, dass** die Hochindexschichten auf Basis von Metalloxid ausgewählt sind aus Titanoxid-, Nioboxidschichten oder Schichten einer ausgehend von Titan und Niob erhaltenen Legierung.

8. Material nach einem der vorstehenden Ansprüche, **dadurch gekennzeichnet, dass** die Antidiffusionsschicht ausgewählt ist aus den Schichten:
- aus Siliciumoxid, aus Aluminiumoxid und aus Silicium- und Aluminiumoxid,
- aus Siliciumnitrid, aus Aluminiumnitrid, aus Silicium- und Aluminiumnitrid, aus Silicium- und Zirkoniumnitriden,
- aus Siliciumoxynitriden, aus Aluminiumoxynitriden und aus Silicium- und Aluminiumoxynitriden.

9. Material nach einem der vorstehenden Ansprüche, **dadurch gekennzeichnet, dass** die Glättungsschicht eine Schicht aus gemischtem Oxid ist, umfassend ein oder mehrere Metalle, ausgewählt aus Zinn Sn, Zink Zn, Gallium Ga und Indium In.

10. Material nach einem der vorstehenden Ansprüche, **dadurch gekennzeichnet, dass** die obere dielektrische Beschichtung mindestens eine Hochindexschicht auf Basis von Metalloxid umfasst, die einen Brechungsindex größer als 2,3 und eine Dicke größer als 5 nm aufweist.

11. Material nach einem der vorstehenden Ansprüche, **dadurch gekennzeichnet, dass** die obere dielektrische Beschichtung mindestens eine dielektrische Schicht umfasst, die einen Brechungsindex kleiner als 2,2 und eine Dicke größer als 5 nm aufweist, angeordnet oberhalb der Hochindexschicht.

12. Material nach einem der vorstehenden Ansprüche, **dadurch gekennzeichnet, dass** die obere dielektrische Beschichtung mindestens eine Schicht mit niedrigem Brechungsindex umfasst, die einen Brechungsindex kleiner als oder gleich 1,7 und eine Dicke größer als 5 nm aufweist.

13. Material nach einem der vorstehenden Ansprüche, **dadurch gekennzeichnet, dass** die obere dielektrische Beschichtung mindestens die in der folgenden Reihenfolge oberhalb der Funktionsschicht abgeschiedene Sequenz von dünnen Schichten umfasst:
- mindestens eine Schicht mit hohem Brechungsindex, aus Material mit Brechungsindex größer als oder gleich 2,20, wobei die physische Dicke der Schicht mit hohem Brechungsindex oder die Summe der physischen Dicken von Schichten mit hohem Brechungsindex zwischen 10 und 40 nm liegt,
- mindestens eine Schicht mit niedrigem Brechungsindex, aus Material mit Brechungsindex kleiner als oder gleich 1,70, wobei die Dicke der Schicht mit niedrigem Brechungsindex oder die Summe der physischen Dicken der Schichten mit niedrigem Brechungsindex zwischen 40 und 120 nm liegt.

14. Material nach einem der vorstehenden Ansprüche, wobei das Substrat aus Glas, insbesondere Kalk-Natron-Silikatglas, oder aus organischem Polymermaterial besteht.

15. Verfahren zum Erhalten eines Materials, umfassend ein mit einem Stapel aus dünnen Schichten beschichtetes transparentes Substrat nach einem der Ansprüche 1 bis 14, wobei die dünnen Schichten durch Kathodenzerstäubung, gegebenenfalls unterstützt durch Magnetfeld, abgeschieden werden, **dadurch gekennzeichnet, dass** eine Wärmebehandlung bei erhöhter Temperatur vom Biege-, Härtungs- oder Glühentyp an dem Substrat vorgenommen wird.

## Claims

1. A material comprising a transparent substrate coated with a stack of thin layers comprising a silver-based functional metal layer and two dielectric coatings, each dielectric coating comprising at least one dielectric layer, so that the functional metal layer is positioned between two dielectric coatings, **characterized in that** a lower dielectric coating located below a silver-based functional layer comprises:
- a high-index layer based on metal oxide, exhibiting a refractive index of greater than 2.3 and a thickness of greater than 5 nm,
- an antidiffusion layer based on silicon and/or on aluminum chosen from an oxide, a nitride and an oxynitride layer, located above the high-index layer, exhibiting a thickness of between 1 and 10 nm,
- a high-index layer exhibiting a thickness lower than 5 nm located above the antidiffusion layer and below the silver-based functional layer,
- at least one oxide-based layer located above the antidiffusion layer and exhibiting a different composition from the antidiffusion layer.

2. The material as claimed in claim 1, **characterized in that** an upper dielectric coating located above a silver-based functional layer comprises at least two thin layers, each with a thickness of greater than 5 nm, the refractive index difference of which is greater than 0.30.

3. The material as claimed in any one of the preceding claims, **characterized in that** the antidiffusion layer is located above and in contact with the high-index layer exhibiting a thickness of greater than 5 nm.

4. The material as claimed in any one of the preceding claims, **characterized in that** the sum of the thicknesses of the oxide-based layers located above the antidiffusion layer in the lower dielectric coating is greater than 5.0 nm.

5. The material as claimed in any one of the preceding claims, **characterized in that** at least one oxide-based layer located above the antidiffusion layer and exhibiting a different composition from the lower dielectric coating is a wetting layer based on zinc oxide, preferably located directly in contact with the silver-based metal layer.

6. The material as claimed in any one of the preceding claims, **characterized in that** the dielectric coating located below the silver-based functional layer comprises, as oxide-based layers:
- a smoothing layer based on mixed oxide, located above the antidiffusion layer and exhibiting a different composition, the smoothing layer being either in contact with the antidiffusion layer or separated from the antidiffusion layer by a layer exhibiting a thickness of less than 5 nm, and
- a wetting layer based on zinc oxide, located above the smoothing layer.

7. The material as claimed in any one of the preceding claims, **characterized in that** the high-index layers based on metal oxide are chosen from titanium oxide or niobium oxide layers or layers of an alloy obtained from titanium and niobium.

8. The material as claimed in any one of the preceding claims, **characterized in that** the antidiffusion layer is chosen from the layers:
- of silicon oxide, of aluminum oxide and of aluminum silicon oxide,
- of silicon nitride, of aluminum nitride, of aluminum silicon nitride, of zirconium silicon nitrides,
- of silicon oxynitrides, of aluminum oxynitrides and of aluminum silicon oxynitrides.

9. The material as claimed in any one of the preceding claims, **characterized in that** the smoothing layer is a layer of mixed oxide comprising one or more metals chosen from tin Sn, zinc Zn, gallium Ga and indium In.

10. The material as claimed in any one of the preceding claims, **characterized in that** the upper dielectric coating comprises at least one high-index layer based on metal oxide exhibiting a refractive index of greater than 2.3 and a thickness of greater than 5 nm.

11. The material as claimed in any one of the preceding claims, **characterized in that** the upper dielectric coating comprises at least one dielectric layer exhibiting a refractive index of less than 2.2 and a thickness of greater than 5 nm located above the high-index layer.

12. The material as claimed in any one of the preceding claims, **characterized in that** the upper dielectric coating comprises at least one layer having a low refractive index exhibiting a refractive index of less than or equal to 1.7 and a thickness of greater than 5 nm.

13. The material as claimed in any one of the preceding claims, **characterized in that** the upper dielectric coating comprises at least the sequence of thin layers deposited in the following order above the functional layer:
- at least one layer having a high refractive index, made of material with a refractive index of greater than or equal to 2.20, the physical thickness of the layer having a high refractive index or the sum of the physical thicknesses of the layers having a high refractive index being between 10 and 40 nm,
- at least one layer having a low refractive index, made of material with a refractive index of less than or equal to 1.70, the physical thickness of the layer having a low refractive index or the sum of the physical thicknesses of the layers having a low refractive index being between 40 and 120 nm.

14. The material as claimed in any one of the preceding claims, such that the substrate is made of glass, in particular soda-lime-silica glass, or of a polymeric organic substance.

15. A process for obtaining a material comprising a transparent substrate coated with a stack of thin layers as claimed in any one of claims 1 to 14, the thin layers being deposited by cathode sputtering, optionally magnetic-field-assisted cathode sputtering, **characterized in that** a high-temperature heat treatment of the bending, tempering or
